(19) Europäisches Patentamt
European Patent Office
Office européen des brevets

(11) **EP 0 715 430 B1**

(12) **FASCICULE DE BREVET EUROPEEN**

(45) Date de publication et mention
de la délivrance du brevet:
**16.06.2004 Bulletin 2004/25**

(51) Int Cl.⁷: **H04L 1/00**, H03M 13/00,
G11B 20/18

(21) Numéro de dépôt: **95203189.6**

(22) Date de dépôt: **21.11.1995**

(54) **Système de transmission au moyen d'informations protégées par un code de gestion d'erreurs**

Übertragungssystem mit fehlerkorrigierendem Paritätskode

Transmission system with error correcting coding using parity codes

(84) Etats contractants désignés:
**DE FR GB**

(30) Priorité: **30.11.1994 FR 9414375**

(43) Date de publication de la demande:
**05.06.1996 Bulletin 1996/23**

(73) Titulaire: **Koninklijke Philips Electronics N.V.
5621 BA Eindhoven (NL)**

(72) Inventeur: **Marchand, Philippe,
Société Civile S.P.I.D.
F-75008 Paris (FR)**

(74) Mandataire: **Chaffraix, Jean et al
Société Civile SPID,
156, Boulevard Haussmann
75008 Paris (FR)**

(56) Documents cités:
**EP-A- 0 076 862          DE-A- 3 006 958
GB-A- 2 082 356          GB-A- 2 082 809
US-A- 3 685 016          US-A- 4 796 260**

# Description

La présente invention concerne un système de transmission au moyen d'informations formées d'une suite d'éléments binaires protégés par un code de gestion d'erreurs qui tient compte, pour au moins deux fois, de la valeur de chaque élément binaire, système comportant :

- un dispositif encodeur muni :

  - d'un accès d'entrée pour des données d'entrée selon une fréquence d'apparition égale à 1/T,
  - d'un premier circuit d'analyse de données pour fournir sur une sortie un code de gestion d'erreurs,
  - d'un circuit de sortie pour fournir sur un accès de sortie des données protégées en affectant aux données d'entrée ledit code de gestion d'erreurs,

- un moyen de transmission pour transmettre les données protégées et
- un dispositif décodeur muni :

  - d'un accès réception pour recevoir les données protégées,
  - d'un circuit de traitement des erreurs et
  - d'un accès de sortie pour fournir des données restituées.

Un tel système trouve d'importantes applications, notamment dans le domaine de transmission de données et aussi dans le domaine de l'enregistrement de celles-ci, le support d'enregistrement, par exemple bande magnétique ou disque compact, étant alors considéré comme un moyen de transmission.

La présente invention concerne aussi un dispositif encodeur et un dispositif décodeur convenant à un tel système.

Il est connu des documents US-A 3 685 016 et US-A 4 796 260 de protéger les informations en ajoutant des codes détecteurs et/ou correcteurs d'erreurs. Cependant ces codes nécessitent le traitement de tout un ensemble de données qu'il faut emmagasiner soit pour établir ces codes soit pour les restituer à l'utilisation en désassemblant les données . Ce traitement par ensembles peut être désavantageux lorsqu'on veut traiter des données à un rythme rapide, puisqu'il faut former tout un ensemble du côté réception et recevoir tout un ensemble pour traiter les données reçues.

La présente invention propose un système de ce genre dans lequel le traitement s'effectue "à la volée".

Pour cela, un tel système est remarquable en ce que le circuit d'analyse de données coopère avec :

- des moyens de parallélisation munis d'une entrée pour recevoir des données et de "n" sorties pour fournir les données en des instants multiples de n × T et comporte,
- des cascades d'éléments de retard pour retarder les données parallélisées en des temps multiples de n × T, munis de points de branchement situés au niveau de chacun des éléments de retard,
- des circuits de combinaisons comportant des entrées branchées sur au moins deux points de branchement de toutes les cascades pour fournir ledit code de gestion d'erreurs.

La description suivante faite en regard des dessins ci-annexés, le tout donné à titre d'exemple non limitatif, fera bien comprendre comment l'invention peut être réalisée.

La figure 1 montre un système de transmission conforme à l'invention.

La figure 2 montre un dispositif encodeur conforme à l'invention.

La figure 3 montre un dispositif décodeur conforme à l'invention.

La figure 4 montre un schéma destiné à l'explication de l'invention.

La figure 5 montre un schéma d'explication pour d'autres variantes de l'invention.

La figure 6 montre un schéma d'explication pour montrer des avantages de l'invention pour la correction d'erreurs en paquets.

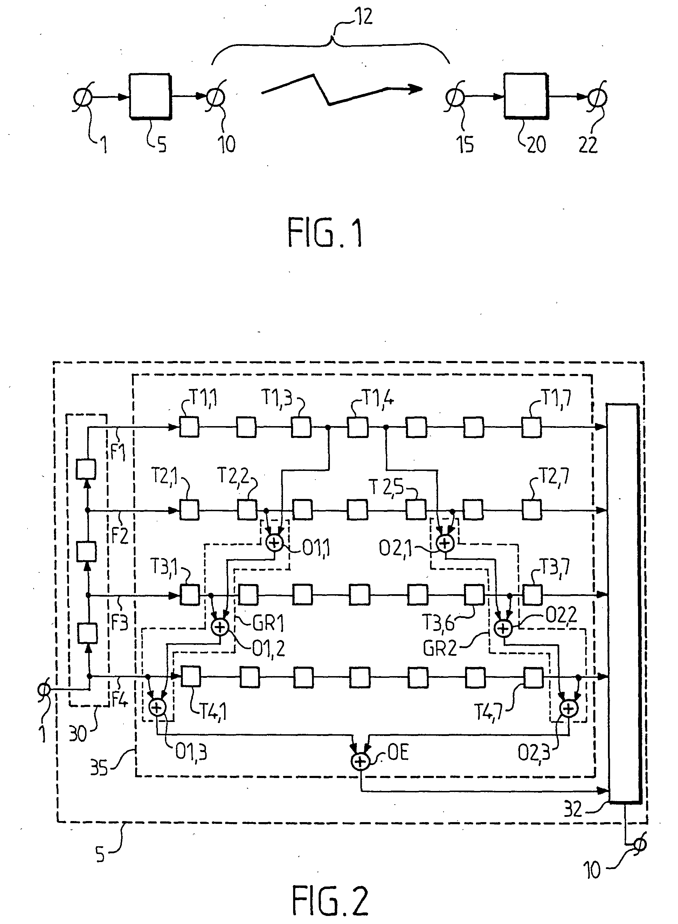

A la figure 1 qui montre un système de transmission conforme à l'invention, la référence 1 indique un accès d'entrée pour une suite d'éléments binaires. Cette suite est traitée par un dispositif encodeur 5 pour fournir, à un accès de sortie 10, une autre suite d'éléments binaires dans laquelle sont insérés des éléments binaires d'un code de gestion d'erreurs. Cette suite constitue les données protégées. Un moyen de transmission 12, non explicité car il est indifférent pour les mesures de l'invention, transmet ces données protégées à l'accès réception 15 d'un dispositif décodeur 20 qui fournit les données restituées à un accès de sortie 22.

Dans le cadre de l'exemple décrit, le code de gestion d'erreurs est un simple code de parité. Chaque élément binaire de la suite sera concerné au moins deux fois par un calcul de parité de sorte qu'il devient possible de corriger quelques erreurs de transmission.

La figure 2 montre un exemple de réalisation d'un dispositif encodeur conforme à l'invention. Il se compose tout d'abord de moyens de parallélisation 30 formés d'un circuit série-parallèle qui transforme la série d'éléments binaires reçus, selon une fréquence égale à 1/T, à l'accès 1 en "n" trains d'éléments binaires. Pour simplifier les explications, le nombre "n" a été pris égal à "4". Ces quatre trains sont rendus disponibles sur des fils F1, F2, F3 et F4 branchés aux sorties de ce circuit 30. Chacun de ces fils est relié à une entrée d'un circuit de sortie 32 par l'intermédiaire d'un circuit d'analyse de données 35. Ce circuit d'analyse 35 est formé de quatre cascades d'éléments de retard connectées chacune à un des fils F1 à F4 : une cascade comprenant les éléments de retard T1,1 à T1,7 est connectée au fil F1, une cascade d'éléments T2,1 à T2,7 est connectée au fil F2, une cascade d'éléments T3,1 à T3,7 est connectée au fil F3 et une cascade d'éléments T4,1 à T4,7 est connectée au fil F4. Chacun de ces éléments de retard apporte un retard égal à $n \times T$. Le circuit de sortie 32 transforme les signaux à ses entrées pour les fournir à l'accès de sortie 10 en effectuant le traitement approprié pour les adapter au milieu de transmission 12.

Pour effectuer le calcul de parité conformément à l'invention, le circuit d'analyse 35 comporte des circuits de combinaison. Ceux-ci sont constitués par deux groupes d'opérateurs "OU-EXCLUSIF" GR1 et GR2 et une porte "OU-EXCLUSIF" OE. Le premier groupe GR1 se compose de trois portes "OU-EXCLUSIF" 01,1 01,2 et 01,3. Les entrées de la porte 01,1 sont branchées aux sorties des éléments de retard T1,3 et T2,2, ce qui représente pratiquement le milieu de la cascade ; les entrées de la porte 01,2 sont branchées à la sortie de la porte 01,1 et de l'élément T3,1 et les entrées de la porte 01,3 à la sortie de la porte 01,2 et de l'entrée de l'élément T4,1. Le deuxième groupe se compose de trois portes "OU-EXCLUSIF" 02,1 02,2 et 02,3. Les entrées de la porte 02,1 sont branchées aux sorties des éléments de retard T1,4 et T2,5, les entrées de la porte 02,2 à la sortie de la porte 02,1 et de l'élément T3,6 et les entrées de la porte 02,3 à la sortie de la porte 02,2 et de la sortie de l'élément T4,7. La porte OE fournit la parité combinée conforme à l'invention. Pour cela, ses entrées sont reliées aux sorties des portes 01,3 et 02,3. Le circuit de sortie 32 se charge aussi de la transmission de cette information de parité.

Ainsi, pour chaque cascade, le branchement se décale d'un élément de retard en avant et d'un élément de retard en arrière.

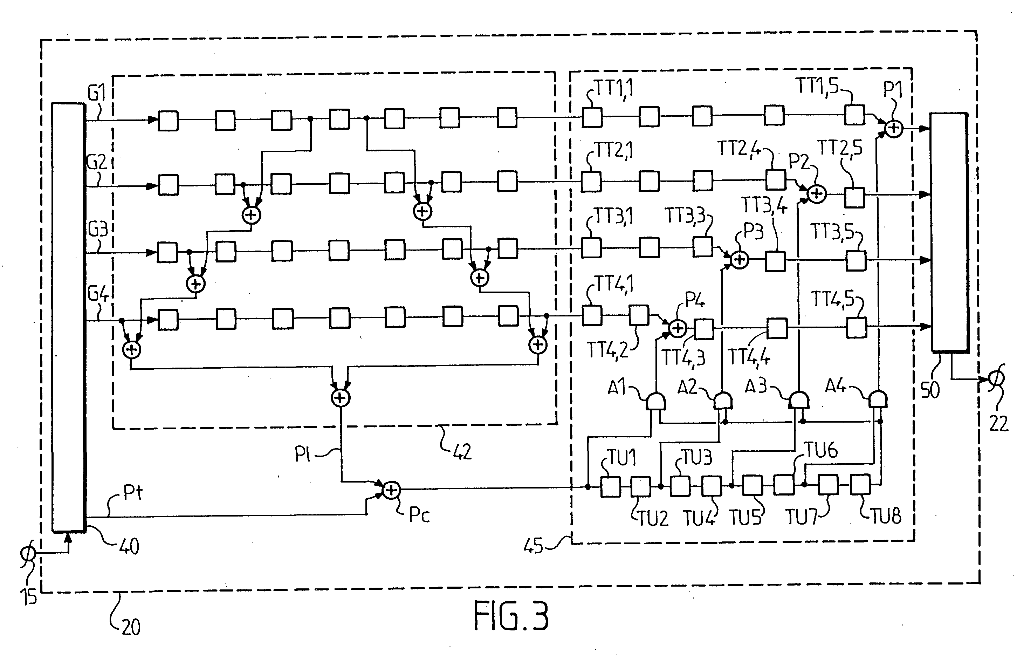

La figure 3 montre un exemple de réalisation d'un dispositif décodeur conforme à l'invention. Il se compose tout d'abord d'un circuit de présentation 40 pour recevoir les données transmises et reçues à l'accès 15. Ce circuit fournit sur des fils G1 à G4 les informations transmises et sur un fil Pt le code de parité transmis élaboré par le circuit d'analyse 35 du dispositif encodeur 5. Un deuxième circuit d'analyse 42 de même structure que le circuit 35 fournit une parité locale Pl qui est comparée avec la parité transmise Pt et relative aux mêmes éléments binaires. Le résultat de cette comparaison est appliqué à un circuit correcteur d'erreurs 45 qui corrige alors les erreurs sur les éléments binaires issus des fils G1 à G4. Un circuit de sortie 50 fournit alors sur l'accès 22 les informations pour l'utilisateur.

Le circuit correcteur d'erreurs 45 est formé de quatre cascades d'éléments de retard montés en cascade comportant chacune des éléments de retard : TT1,1 à TT1,5 pour la première, TT2,1 à TT2,5 pour la deuxième, TT3,1 à TT3,5 pour la troisième et TT4,1 à TT4,5 pour la quatrième. Différentes portes OU-EXCLUSIF P1 à P4 sont insérées dans ces cascades pour changer la valeur des éléments binaires. Pour cela, la porte P1 a une de ses entrées reliée à la sortie de l'élément TT1,5, et sa sortie est reliée au circuit 50, la porte P2 a une de ses entrées reliée à la sortie de l'élément TT2,4 et sa sortie à l'entrée de l'élément TT2,5, la porte P3 a une de ses entrées reliée à la sortie de l'élément TT3,3 et sa sortie à l'entrée de l'élément TT3,4 et la porte P4 a une de ses entrées reliée à la sortie de l'élément TT4,2 et sa sortie à l'entrée de l'élément TT4,3. Les autres entrées des portes P1 à P4 sont reliées respectivement aux sorties de portes ET A1 à A4. Une entrée de toutes ces portes est reliée à la sortie d'un élément de retard TU8 faisant partie d'une série d'éléments de retard TU1 à TU8 connectée à la sortie d'une porte OU-EXCLUSIF PC qui effectue la comparaison des parités à la sortie PI et à la parité Pt fournie par le circuit 35.

Ainsi, les portes A1 à A4 fournissent un "1" à leur sortie lorsque deux codes de mauvaise parité sont appliqués à leur entrée, on peut alors corriger l'élément binaire qui a engendré ces deux mauvaises parités.

## CONSIDERATIONS THEORIQUES SUR L'INVENTION.

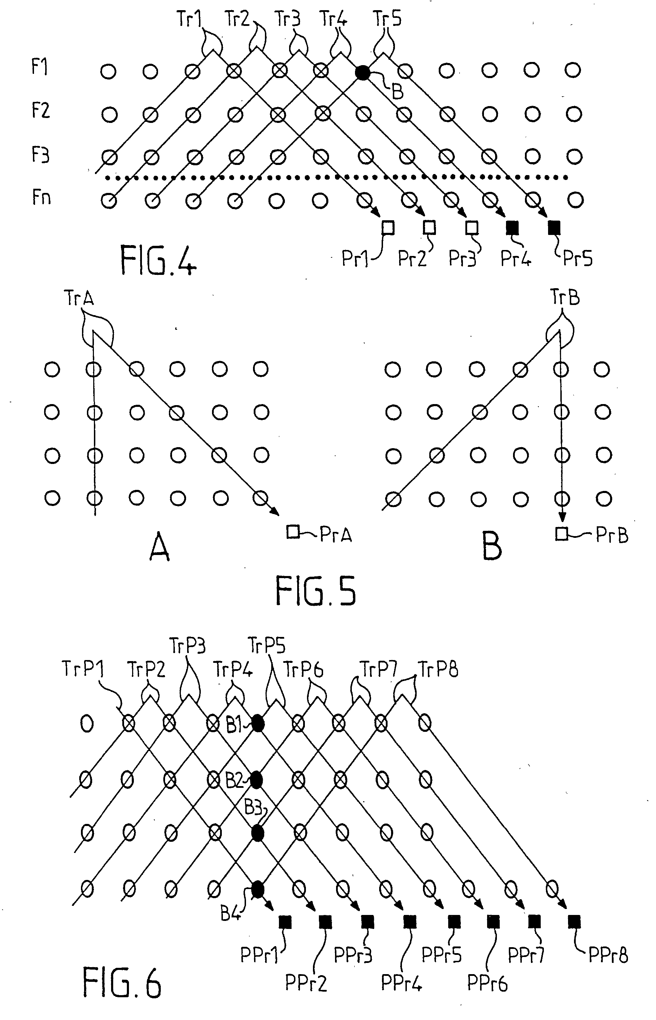

Les données à coder, supposées disponibles sous forme série, sont "parallélisées" sur n trains, disponibles sur des fils F1 à Fn, ce qui est représenté à la figure 4, les bits des n trains parallèles sont représentés par des petits ronds. On effectue ensuite un simple calcul de parité selon les mots de 2n bits définis selon les trajectoires Tr1 à Tr5 représentées. Les bits de parité Pr1 à Pr5 obtenus sont symbolisés par des petits carrés.

Un bit quelconque des données se trouve toujours à l'intersection de deux "trajectoires" et de deux seulement. Cela signifie qu'en cas de transmission erronée d'un bit d'information, on observera une divergence, dite de parité (obtenue en comparant les bits de redondance transmis à ceux qui seront recalculés en réception en suivant le même principe), de deux bits de parité (redondance). Les "trajectoires" associées à ces deux bits, étant connues par principe, permettent de localiser à leur intersection le bit erroné et d'en effectuer la correction en inversant sa valeur. C'est le cas, par exemple, pour les bits de parité Pr4 et Pr5, représentés par des carrés noirs, qui ne concordent pas avec ceux qui ont été émis (après calcul à la réception). Il s'ensuit que le bit "B" situé à l'intersection des 2 trajectoires Tr4 et Tr5 associées à Pr4 et Pr5 a subi une erreur de transmission.

## PROPRIETES DU CODE

    a- Ce code s'apparente fortement aux codes en blocs, bien qu'on ne puisse définir de bloc à proprement parler (les blocs sont entrelacés).

b- La limite du code est atteinte lorsque 2 bits appartenant à une même "trajectoire" sont erronés. Ceci permet d'estimer la valeur approchée de l'efficacité de correction.

Si les données sont partagées en "n" trains, la redondance est de 1 bit pour n bits de données (surdébit de $n+1/n - 1)100$ en %).

En présence d'un taux d'erreur de transmission de P (probabilité d'erreur par bit avant correction), la probabilité d'avoir 2 bits erronés appartenant à une même trajectoire est environ de $2nP^2$ (avec P faible).

Par comparaison avec le code de Hamming pour lequel m bits de redondance sont ajoutés à des blocs de $2^m-1$ bits d'information et pour lequel la limite de correction correspond à environ $2^mP^2$ (pour m grand), on suppose un même taux d'erreur après correction pour les deux codes :

Hamming :     $2^mP^2 \rightarrow$ redondance $\approx 100$ m/$2^m$     en %
parité entrelacée :     $2nP^2 \rightarrow$ redondance $\approx 100/n$     en %

$$\text{Si } 2^mP^2 = 2nP^2 \Rightarrow n = 2^{m-1} :$$

redondance du code de Hamming : $100$ m/$2^m = R_H$
redondance du code à parité entrelacée : $100/2^{m-1} = R_p$

$$R_H/R_p = m/2.$$

En général le paramètre m pour un code de Hamming est choisi assez grand (m $\geq$ 5) et la relation $R_H/R_p = m/2$ montre que la redondance d'un code à parité entrelacée tel que proposé est nettement plus faible à efficacité de correction équivalente.
Inversement, à redondance équivalente :

$$100 \text{ m}/2^m = 100/n \Rightarrow n = 2^m/m$$

les taux d'erreur après correction sont respectivement :

$$P_H = 2^mP^2 \text{ (Hamming)}$$

$$P_p = 2nP^2 = 2^{m+1}/m \ P_2 \text{ (parité entrelacée)}$$

$$P_H/P_p = m/2 \Rightarrow$$

On en déduit donc qu'à redondances équivalentes le taux d'erreur après correction d'un code de Hamming est m/2 fois plus fort que pour un code à parité entrelacée.

## VARIANTE

Il existe une autre classe de trajectoires présentant des propriétés identiques : voir figure 5 en A et B qui montre deux types de trajectoires TrA et TrB qui permettent d'obtenir deux bits de parité PrA et PrB. Ces trajectoires nécessitent une mémoire de taille réduite.

## Remarque :

Il est montré à figure 6 que les trajectoires du type montré à la figure 4 sont favorables à la correction de "paquets" d'erreurs. Ainsi des divergences de parité PPr1 à PPr8 associées à des trajectoires TrP1 à TrP8 permettent de corriger les paquets $B_1$ à $B_4$ de bits erronés successifs.

Cette propriété n'est pas satisfaite, sans artifice complexe, pour un code en bloc. Elle sera d'autant plus efficace que n est grand.

De ces différentes trajectoires, il découle que les "n" premières cascades sont munies chacune de deux points de branchement situés pour des retards égaux, respectivement, à $(p-j+1)x(nxT)$ et à $p+jx(nxT)$ avec j=1..n et p représentant le nombre moitié du total des éléments de retard pour l'une, montrée figure 4 et que les "n" premières cascades sont munies chacune de deux points de branchement situés pour des retards égaux, respectivement, à $px(nxT)$ et à $p+jx(nXt)$ avec j=1..n et p représentant le nombre moitié du total des éléments de retard pour l'autre, montrée figure 5. Les éléments changeurs sont disposés après un retard égal à $(q+1-j)x(nxT)$ avec j=1..n et q représentant le nombre moitié du total des éléments de retard.

## Revendications

1. Système de transmission au moyen d'informations formées d'une suite d'éléments binaires protégés par un code de gestion d'erreurs qui tient compte, pour au moins deux fois, de la valeur de chaque élément binaire, système comportant :

   - un dispositif encodeur (5) muni :

     • d'un accès d'entrée (1) pour des données d'entrée selon une fréquence d'apparition égale à 1/T,
     • d'un premier circuit d'analyse de données (35) pour fournir sur une sortie un code de gestion d'erreurs,
     • d'un circuit de sortie (32) pour fournir sur un accès de sortie (10) des données protégées en affectant aux données d'entrée ledit code de gestion d'erreurs,

- un moyen de transmission (12) pour transmettre les données protégées et

- un dispositif décodeur (20) muni :

  • d'un accès réception (15) pour recevoir les données protégées,
  • d'un circuit de traitement des erreurs (45) et
  • d'un accès de sortie (22) pour fournir des données restituées,

système **caractérisé en ce que** le circuit d'analyse de données coopère avec :

- des moyens de parallélisation (30) munis d'une entrée (1) pour recevoir des données et de "n" sorties pour fournir les données en des instants multiples de n $\times$ T,

et comporte :

- des premières cascades d'éléments de retard pour retarder les données parallélisées en des temps multiples de n x T, munis de points de branchement situés au niveau de chacun des éléments de retard,
- des circuits de combinaisons (GR1, GR2, OE) comportant des entrées branchées sur au moins deux points de branchement de toutes les cascades pour fournir ledit code de gestion d'erreurs
- un circuit de sortie (32) pour fournir des données, accompagnées d'un code de gestion d'erreurs à partir de données issues dudit circuit d'analyse à la cadence 1/nT.

2.  Système de transmission selon la revendication 1, **caractérisé en ce que** le circuit décodeur (20) comporte :

- un circuit de présentation de données (40) transmises pour présenter les données transmises d'une part et le code de gestion transmis d'autre part, à une cadence de 1/nT
- un deuxième circuit d'analyse de données (42) muni d'une entrée pour recevoir les données transmises,
- un accès pour recevoir ledit code de gestion d'erreurs,
- un élément de comparaison (Pc) pour fournir un signal de comparaison résultat de la comparaison du code de gestion transmis et du code de gestion du deuxième circuit d'analyse,
- un circuit correcteur (45) pour corriger les éléments binaires en fonction du signal de comparaison.
- un circuit de sortie (50) pour fournir des données issues du circuit d'analyse à la cadence de 1/nT.

3.  Système de transmission selon l'une des revendications 1 ou 2, **caractérisé en ce que** le circuit correcteur (45) est formé :

- de "n" deuxièmes cascades d'éléments de retard pour retarder les données parallélisées en des temps multiples de n x T, dans lesquels sont disposés des éléments changeurs de valeurs de données munis d'entrées pour recevoir ledit signal de comparaison.

4.  Système de transmission selon l'une des revendications 1 à 3 **caractérisé en ce que** les "n" premières cascades sont munies chacune de deux points de branchement situés pour des retards égaux, respectivement, à (p-j+1) $\times$ (n $\times$ T) et à p+j $\times$ (n $\times$ T) avec j = 1...n et p représentant le nombre moitié du total des éléments de retard.

5.  Système de transmission selon l'une des revendications 1 à 3 **caractérisé en ce que** les "n" premières cascades sont munies chacune de deux points de branchement situés pour des retards égaux, respectivement, à p $\times$ (n $\times$ T) et à p+j $\times$ (n $\times$ T) avec j = 1...n et p représentant le nombre moitié du total des éléments de retard.

6.  Système de transmission selon l'une des revendications 1 à 3 **caractérisé en ce que** dans les "n" deuxièmes cascades les éléments changeurs sont disposés après un retard égal à (q+1-j) $\times$ (n $\times$ T) avec j = 1...n et q représentant le nombre moitié du total des éléments de retard.

7.  Système de transmission selon l'une des revendications 1 à 6 **caractérisé en ce que** le code de gestion d'erreur est un code de parité.

8.  Circuit encodeur convenant à un système de transmission selon l'une des revendications 1 à 7, **caractérisé en ce qu'**il est muni :

  • d'un accès d'entrée (1) pour des données d'entrée selon une fréquence d'apparition égale à 1/T,
  • d'un premier circuit d'analyse de données (35) pour fournir sur une sortie un code de gestion d'erreurs, coopérant avec :

    - des moyens de parallélisation munis d'une entrée pour recevoir des données et de "n" sorties pour fournir les données en des instants multiples de n x T,

    et comporte :

- des cascades d'éléments de retard pour retarder les données parallélisées en des temps multiples de n x T, munis de points de branchement situés au niveau de chacun des éléments de retard,
- des circuits de combinaisons (GR1, GR2, OE) comportant des entrées branchées sur au moins deux points de branchement de toutes les cascades pour fournir ledit code de gestion d'erreurs,

• d'un circuit de sortie (32) pour fournir sur un accès de sortie (10) des données protégées en affectant aux données d'entrée ledit code de gestion d'erreurs.

9. Circuit décodeur convenant à un système de transmission comportant:

- un dispositif encodeur muni:

  • d'un accès d'entrée (1 ) pour des données d'entrée selon une fréquence d'apparition égale à 1/T
  • d'un premier circuit d'analyse de données (35) pour fournir sur une sortie un code de gestion d'erreurs,
  • d'un circuit de sortie (32) pour fournir sur un accès de sortie des données protégées en affectant aux données d'entrée ledit code de gestion d'erreurs.

selon l'une des revendications 1 à 7, **caractérisé en ce qu'**il est muni :

- d'un circuit de présentation de données (40) transmises pour présenter les données transmises d'une part et le code de gestion transmis d'autre part, à une cadence de 1/nT
- d'un deuxième circuit d'analyse de données (42) muni d'une entrée pour recevoir les données transmises,
- d'un accès pour recevoir ledit code de gestion d'erreurs
- d'un élément de comparaison (Pc) pour fournir un signal de comparaison résultat de la comparaison du code de gestion transmis et du code de gestion du deuxième circuit d'analyse,
- d'un circuit de traitement des erreurs (45) pour corriger les éléments binaires en fonction du signal de comparaison.
- un circuit de sortie (50) pour fournir des données issues du circuit d'analyse à la cadence de 1/nT.

**Patentansprüche**

1. Übertragungssystem mittels Informationen gebildet aus einer Folge von binären Elementen geschützt durch einen Fehlerverwaltungskode welcher zumindest zwei Mal den Wert jedes binären Elements berücksichtigt, ein System mit:

- einer Kodiervorrichtung (5) mit:

  * einem Eingangszugang (1) für die Eingangsdaten je nach einer Erscheinungsfrequenz gleich 1/T,
  * einer ersten Datenanalyseschaltung (35) für die Ausgabe an einem Ausgang eines Fehlerverwaltungskodes,
  * einer Ausgangsschaltung (32) für die Ausgabe an einem Ausgangszugang (10) von geschützten Daten unter Zuteilung an die Eingangsdaten des besagten Fehlerverwaltungskodes,

- einem Übertragungsmittel (12) für die Übertragung der geschützten Daten und
- einer Dekodiervorrichtung (20) mit:

  * einem Empfangszugang (15) für den Empfang der geschützten Daten,
  * einer Fehlerverarbeitungsschaltung (45) und
  * einem Ausgangszugang (22) für die Ausgabe der wiederhergestellten Daten, **dadurch gekennzeichnete**s System, dass die Datenanalyseschaltung kooperiert mit:

- Parallelisierungsmitteln (30) versehen mit einem Eingang (1) für den Erhalt von Daten und mit "n" Ausgängen für die Ausgabe der Daten in multiplen Zeitpunkten von n x T, und es enthält:

- ersten Kaskaden von Verzögerungsmitteln für die Verzögerung der parallelisierten Daten mit multiplen Zeiten von n x T, versehen mit Anschlusspunkten auf der Ebene jedes Verzögerungselements,
- Kombinationsschaltungen (GR1, GR2, OE) mit Eingängen, welche an mindestens zwei Anschlusspunkte aller Kaskaden angeschlossen sind, um den besagten Fehlerverwaltungskode auszugeben,
- einer Ausgangsschaltung (32) für die Ausgabe von Daten in Begleitung eines Fehlerverwaltungskodes anhand der aus der besagten Analyseschaltung im Takt 1/nT kommenden Daten.

2. Übertragungssystem nach Anspruch 1, **dadurch gekennzeichnet, dass** die Dekodierschaltung (20) enthält:

- eine Präsentationsschaltung (40) einerseits für die Präsentation der übertragenen Daten und andererseits des übertragenen Verwaltungskodes in einem Takt von 1/nT,
- eine zweite Datenanalyseschaltung (42) versehen mit einem Eingang für den Erhalt der übertragenen Daten,
- einen Zugang für den Erhalt des besagten Fehlerverwaltungskodes,
- ein Vergleichselement (Pc) für die Ausgabe eines Vergleichssignals als Ergebnis des Vergleichs des übertragenen Verwaltungskodes mit dem Verwaltungskode der zweiten Analyseschaltung,
- eine Korrekturschaltung (45) für die Korrektur der binären Elemente unter Berücksichtigung des Vergleichssignals,
- eine Ausgangsschaltung (50) für die Ausgabe der Daten aus der Analyseschaltung im Takt 1/nT.

3. Übertragungssystem nach einem der Ansprüche 1 bis 2, **dadurch gekennzeichnet, dass** die Korrekturschaltung (45) besteht aus:

- "n" zweiten Kaskaden von Verzögerungsmitteln für die Verzögerung der parallelisierten Daten mit multiplen Zeiten von n x T, in denen Elemente zum Wechseln der Datenwerte angeordnet und mit Eingängen versehen sind, um das besagte Vergleichssignal zu erhalten.

4. Übertragungssystem nach einem der Ansprüche 1 bis 3, **dadurch gekennzeichnet, dass** die "n" ersten Kaskaden jeweils mit zwei Anschlusspunkten versehen sind, angeordnet für respektive gleiche Verzögerungen von (p-j+1) x (n x T) und p+j x (n x T) mit j=1..n, und p bezeichnet die halbe Anzahl der gesamten Verzögerungselemente.

5. Übertragungssystem nach einem der Ansprüche 1 bis 3, **dadurch gekennzeichnet, dass** die "n" ersten Kaskaden jeweils mit zwei Anschlusspunkten versehen sind, angeordnet für respektive gleiche Verzögerungen von p x (n x T) und p+j x (n x T) mit j=1..n, und p bezeichnet die halbe Anzahl der gesamten Verzögerungselemente.

6. Übertragungssystem nach einem der Ansprüche 1 bis 3, **dadurch gekennzeichnet, dass** in den "n" zweiten Kaskaden die Wechselelemente angeordnet sind nach einer Verzögerung gleich (q+1-j) x (n x T) mit j=1..n, und q bezeichnet die halbe Anzahl der gesamten Verzögerungselemente.

7. Übertragungssystem nach einem der Ansprüche 1 bis 6, **dadurch gekennzeichnet, dass** der Fehlerverwaltungskode ein Paritätskode ist.

8. Kodierschaltung geeignet für ein Übertragungssystem nach einem der Ansprüche 1 bis 7, **dadurch gekennzeichnet, dass** sie versehen ist mit:

* einem Eingangszugang (1) für die Eingangsdaten nach einer Erscheinungsfrequenz gleich 1/T,
* einer ersten Datenanalyseschaltung (35) für die Ausgabe an einem Ausgang eines Fehlerverwaltungskodes in Kooperation mit:

  - Parallelisierungsmitteln versehen mit einem Eingang für den Erhalt von Daten und mit "n" Ausgängen für die Ausgabe der Daten in multiplen Zeitpunkten von n x T, und mit:
  - Kaskaden von Verzögerungsmitteln für die Verzögerung der parallelisierten Daten mit multiplen Zeiten von n x T, versehen mit Anschlusspunkten auf der Ebene jedes Verzögerungselements,
  - Kombinationsschaltungen (GR1, GR2, OE) mit Eingängen, welche an mindestens zwei Anschlusspunkte aller Kaskaden angeschlossen sind, um den besagten Fehlerverwaltungskode auszugeben,

* einer Ausgangsschaltung (32) für die Ausgabe an einem Ausgangszugang (10) von geschützten Daten unter Zuteilung an die Eingangsdaten des besagten Fehlerverwaltungskodes.

9. Dekodierschaltung geeignet für Übertragungssystem mit:

* einem Eingangszugang (1) für die Eingangsdaten nach einer Erscheinungsfrequenz gleich 1/T,
* einer ersten Datenanalyseschaltung (35) für die Ausgabe an einem Ausgang eines Fehlerverwaltungskodes,
* einer Ausgangsschaltung (32) für die Ausgabe an einem Ausgangszugang von geschützten Daten unter Zuteilung an die Eingangsdaten des besagten Fehlerverwaltungskodes

nach einem der Ansprüche 1 bis 7, **dadurch gekennzeichnet, dass** sie enthält:

- eine Präsentationsschaltung (40) einerseits für die Präsentation der übertragenen Daten und andererseits des übertragenen Verwaltungskodes in einem Takt von 1/nT,
- eine zweite Datenanalyseschaltung (42) versehen mit einem Eingang für den Erhalt der übertragenen Daten,
- einen Zugang für den Erhalt des besagten Fehlerverwaltungskodes,
- ein Vergleichselement (Pc) für die Ausgabe eines Vergleichssignals als Ergebnis des Vergleichs des übertragenen Verwaltungskodes mit dem Verwaltungskode der zweiten Analyseschaltung,
- eine Fehlerverarbeitungsschaltung (45) für die Korrektur der binären Elemente unter Berücksichtigung des Vergleichssignals,
- eine Ausgangsschaltung (50) für die Ausgabe der Daten aus der Analyseschaltung im Takt 1/nT.

## Claims

1. A transmission system via communications formed by a bit string protected by an error management code which takes into account, at least twice, the value of each bit, which system comprises:

   - an encoding device (5) which has:

     • an input access (1) for input data that have a fade-in frequency equal to 1/T,
     • a first data analysis circuit (35) for producing an error management code on an output,
     • an output circuit (32) for producing protected data on an output access (10) by assigning said error management code to the input data, and

   - a transmitting means (12) for transmitting the protected data and
   - a decoding device (20) which has:

     • a receiving access (15) for receiving the protected data,
     • an error processing circuit (45), and
     • an output access (22) for producing recovered data,

   which system is **characterized in that** the data analysis circuit comprises:
   - serial-to-parallel converting means (30), which have an input (1) for receiving data and "n" outputs for producing the data at instants which are multiples of nxT,
   - first cascade combinations of delay elements, for delaying the parallel-converted data in time periods which are multiples of n x T, which cascade combinations have tapping points at each of the delay elements,
   - combining circuits (GR1, GR2, OE) which have inputs connected to at least two tapping points of all the cascade combinations to produce said error management code.
   - an output circuit (32) for supplying data accompanied by an error management code based on data coming from said analysis at a rate of 1/nT.

2. A transmission system as claimed in Claim 1, **characterized in that** the decoding circuit (20) comprises:

   - a distributing circuit (40) for distributing transmitted data to distribute the transmitted data on the one hand and the transmitted management code on the other, at a rate of 1/nT,
   - a second data analysis circuit (42) having an input for receiving the transmitted data,
   - an access for receiving said error management code,
   - a comparing element (Pc) for supplying a comparison signal which is the result of the comparison of the transmitted management code and the management code of the second analysis circuit,
   - a correction circuit (45) for correcting the bits as a function of the comparison signal.
   - an output circuit (50) for supplying data coming from the analysis circuit at a rate of 1/nT.

3. A transmission system as claimed in one of the Claims 1 or 2, **characterized in that** the correction circuit (45) is formed by:

   - "n" second cascade combinations of delay elements for delaying the parallel-converted data in periods of time which are multiples of n x T, which combinations include data value changers which have inputs for receiving said comparison signal.

4. A transmission system as claimed in one of the Claims 1 to 3, **characterized in that** the "n" first cascade combinations have each two tapping points for delays equal to, (p-j+1) x (n x T) and to p+j x (n x T) respectively, where j = 1 ... n, and p represents the average total number of delay elements.

5. A transmission system as claimed in one of the Claims 1 to 3, **characterized in that** the "n" first cascade combinations have each two tapping points for delays which are equal to p x (n x T) and to p+j x (n x T) respectively, where j = 1 ... n, and p represents half the total number of delay elements.

6. A transmission system as claimed in one of the Claims 1 to 3, **characterized in that** in the "n" second cascade combinations the changing elements are arranged after a delay element equal to (q+1-j) x (n x T), where j = 1 ... n, and q represents half the total number of delay elements.

7. A transmission system as claimed in one of the Claims 1 to 6, **characterized in that** the error management code is a parity code.

8. An encoding circuit suitable for a transmission system as claimed in one of the Claims 1 to 7, **characterized in that** it has

- • an input access (1) for input data that have a fade-in frequency equal to 1/T,
- • a first data analysis circuit (35) for producing an error management code on an output, cooperating with:

  - serial-to-parallel converting means which have an input for receiving data and "n" outputs for producing the data at instants which are multiples of nxT and comprises,
  - cascade combinations of delay elements, for delaying the parallel-converted data in time periods which are multiples of n x T, which cascade combinations have tapping points at each of the delay elements,
  - combining circuits (GR1, GR2, OE) which have inputs connected to at least two tapping points of all the cascade combinations to produce said error management code.

- • an output circuit (32) for producing protected data on an output access (10) by assigning said error management code to the input data.

9. A decoding circuit suitable for a transmission system as claimed in one of the claims 1 to 7, comprising

  - an encoding device having:

    - • an input access (1) for input data that have a fade-in frequency equal to 1/T,
    - • a first data analysis circuit (35) for producing an error management code on an output,
    - • an output circuit (32) for producing protected data on an output access by assigning said error management code to the input data,

  the decoding circuit comprising

    - a distributing circuit (40) for distributing transmitted data to distribute the transmitted data on the one hand and the transmitted management code on the other, at a rate of 1/nT,
    - a second data analysis circuit (42) having an input for receiving the transmitted data,
- an access for receiving said error management code
- a comparing element (Pc) for supplying a comparison signal which is the result of the comparison of the transmitted management code and the management code of the second analysis circuit,
- a correction circuit (45) for correcting the bits as a function of the comparison signal.
- an output circuit (50) for supplying data coming from the analysis circuit at a rate of 1/nT.

FIG.1

FIG.2

FIG.3

EP 0 715 430 B1

Tr1  Tr2  Tr3  Tr4  Tr5

F1

B

F2

F3

Fn

Pr1  Pr2  Pr3  Pr4  Pr5

FIG.4

TrA                                    TrB

A                                      B

PrA                                    PrB

FIG.5

TrP1  TrP2  TrP3  TrP4  TrP5  TrP6  TrP7  TrP8

B1

B2

B3

B4

PPr1  PPr2  PPr3  PPr4  PPr5  PPr6  PPr7  PPr8

FIG.6